# EUROPEAN PATENT SPECIFICATION

(11) **EP 4 422 863 B1**
(45) Date of publication and mention of the grant of the patent: **26.03.2025**
(21) Application number: 22818106.1
(22) Date of filing: 28.10.2022
(51) Int. Cl.: B32B 7/12, B32B 27/08, B32B 27/36, H01L 31/049

(54) **INTERMEDIATE FILM FOR A PHOTOVOLTAIC MODULE, METHOD FOR FORMING SAME AND METHOD FOR FORMING A PHOTOVOLTAIC MODULE TECHNICAL FIELD**
ZWISCHENFOLIE FÜR EIN PHOTOVOLTAIKMODUL, VERFAHREN ZU DEREN HERSTELLUNG UND VERFAHREN ZUR HERSTELLUNG EINES PHOTOVOLTAIKMODULS
FILM INTERMÉDIAIRE POUR MODULE PHOTOVOLTAÏQUE, SON PROCÉDÉ DE FORMATION ET PROCÉDÉ DE FORMATION D'UN MODULE PHOTOVOLTAÏQUE

(30) Priority: 28.10.2021 IT 202100027614
(43) Date of publication of application: 04.09.2024
(73) Proprietor: Coveme S.p.A., 34170 Gorizia (IT)
(72) Inventor: VENTURELLI, Lorenzo, 34170 Gorizia (IT)
(74) Representative: Grünecker Patent- und Rechtsanwälte PartG mbB
(86) International application number: PCT/IB2022/060377
(87) International publication number: WO 2023/073628

(56) References cited:
- EP-A1- 2 584 613
- EP-A1- 2 862 903
- US-A1- 2011 045 191
- US-A1- 2017 133 530

## Description

### TECHNICAL FIELD

The present invention relates to the technical field of photovoltaic modules. More in particular, the present invention relates to an optimized method for the production of photovoltaic modules and to an intermediate product to speed up the production of photovoltaic modules.

### STATE OF THE ART

Solar cells are used to convert sunlight into electricity by exploiting the photovoltaic effect: hence, they are one of the most promising alternative energy sources to replace fossil fuels. Solar cells are produced from semiconductor materials and are assembled to form the so-called photovoltaic modules, which, in turn, are grouped together to form the photovoltaic systems typically installed on the roofs of houses or the like.

To form photovoltaic modules, groups of solar cells are typically encapsulated by means of an encapsulating material such as Ethylene Vinyl Acetate (EVA). The encapsulating material enclosing the solar cells is then sandwiched between a surface layer and a backsheet, in order to complete the photovoltaic module. The surface layer, or main surface of the module, typically made of glass or thermoplastic materials, covers the surface of the module exposed to the sun and allows sunlight to reach the cells. The backsheet, in turn, performs several functions. First of all, the backsheet protects the encapsulating material and solar cells from environmental agents, for example, preventing moisture, oxygen, and other weather-related factors from damaging the encapsulating material and cells. In the second place, the backsheet ensures the electrical insulation of the cells and of the corresponding electrical circuits. Moreover, the backsheet makes it possible to increase the mechanical strength of the module and to protect the encapsulating material and the cells from mechanical damage. Finally, the backsheet should exhibit high opacity for aesthetic purposes and high reflectivity for functional purposes.

Backsheets known to the state of the art generally consist of two or more layers, for example, one or more layers of PET to provide electrical insulation of the photovoltaic module and protection from weathering, and an overlay layer of resin to promote adhesion of the PET to the encapsulating layer. Examples of backsheets formed by a PET layer and an adhesive resin are described in EP 2 730 406 A1.

During the step of production of the backsheet, a layer of resin is generally spread over the previously treated PET film (e.g., subjected to corona treatment, plasma treatment, or chemical etching treatment) and then the PET film covered by the resin layer is exposed to high temperatures for solvent evaporation; cross-linking of the resin then follows. For this purpose, special cross-linking agents, such as aliphatic poly-isocyanates, are added to the resin, but these are not very reactive and therefore require long exposures to temperatures above ambient temperatures to complete the cross-linking step. Upon completion of the cross-linking step, the backsheet, already wound into reels, is trimmed and laminated to the photovoltaic module encapsulant. Since the step of cross-linking of the resin can take up to six days, depending on the type of cross-linking agent used and depending on the temperature of the aging chamber, and since the backsheet must subsequently be laminated to the remaining layers of the photovoltaic module, the process of producing backsheets and photovoltaic modules known to the state of the art is long and complex.

In view of the aforementioned problems and disadvantages regarding the manufacturing process of photovoltaic modules, the purpose of the present invention is to provide photovoltaic modules in which the cross-linking process is optimized. In particular, an object of the present invention is to divide the cross-linking process into two sub-steps, a first sub-step involving partial cross-linking of the resin layer spread on the substrate film in the ovens of the coating line and a second sub-step involving the completion of the cross-linking of the resin layer in the ovens for lamination. This is achieved, according to the present invention, by replacing the cross-linking agents added to the resin and by using blocked isocyanates instead.

EP 2 584 613 A1 discloses a weatherable backsheet for a solar cell module, comprising a water-impermeable sheet; and a cured coating film layer disposed on at least one surface of the water-impermeable sheet. The cured coating film layer is formed to the water-impermeable sheet by applying a coating composition containing a hydroxylated fluoropolymer, specific silicon oxide particles, and a curing agent on at least one surface of the sheet, incompletely curing the resultant coating film to degree of cross-linking of 80% to 99%, rolling the resultant laminate. In the ageing step, the cured coating film of the rolled laminate is completely cured.

### SUMMARY

The present invention is based on the idea of optimizing and speeding up the production process of photovoltaic modules.

In the context of the present disclosure, the terms "top," "bottom," "lower," "upper," "high," "low", "front", and "back," where not otherwise specified, refer to the reciprocal placement of the various layers considering a sectional view of the final design of the structure in which the sun-facing surface occupies the highest level.

Furthermore, in this disclosure, it should be understood that the term "intermediate film" refers to an intermediate configuration of the backsheet for photovoltaic modules, that is, a backsheet configuration prior to the final stage. In particular, the intermediate film comprises a substrate film covered by the partially cross-linked resin layer. The intermediate film forms a stand-alone structure and can be wound and stored in reels before being applied to the encapsulant of the photovoltaic modules.

According to an embodiment of the present invention, a method for forming an intermediate film for a backsheet for photovoltaic modules according to claim 1 is provided.

This solution is advantageous because it is possible to make an intermediate structure comprising a substrate film covered with a partially cross-linked resin to be used later to form the backsheet of photovoltaic modules. Since the cross-linking process is stopped before its completion, that is, before the cross-linking of the entire resin layer is achieved, the intermediate film is made faster than the final backsheet with the fully cross-linked resin. In this way, costs and production times are saved. The cross-linking of the resin layer of the intermediate film is subsequently completed during the lamination of the intermediate film itself to the other layers of the photovoltaic module, therefore the photovoltaic module in the final configuration after lamination includes the fully cross-linked resin layer and thus possesses the same properties as standard photovoltaic modules.

According to a preferred configuration, the substrate film may include a PET film, for example, a film consisting of one or two layers of PET. The function of the PET film is to provide electrical insulation to the photovoltaic module and to protect the solar cells from weathering at the rear. Preferably, a white-colored bi-oriented PET film with high hydrolysis and UV resistance is used.

According to a preferred configuration, the cross-linking of the resin layer can be interrupted before it is completed, thus reducing the time the intermediate film stays in the ovens of the deposition and coating line at a temperature above the unblocking temperature of the blocked cross-linking agent. Preferably, the cross-linking of the resin layer can be stopped when the resin layer is no longer wet, but it is dry, and when the intermediate film can be wound and stored in reels without the different resin layers sticking together. For example, it is possible to use ovens in the coating line at a standard temperature between 100°C and 150°C and to increase the conveying speed of the transport rollers compared to the standard production process, so as to decrease the dwell time of the intermediate film in the ovens and to speed up the production process. For example, it is possible to convey the intermediate film in the ovens of the coating line at a temperature between 100°C and 150°C for an exposure time between 10 seconds and 25 seconds, preferably between 15 seconds and 20 seconds. According to a preferred configuration, the cross-linking of the coating resin can be interrupted by stopping the heating process of the sample, if the cross-linking is induced by a temperature increase. According to a preferred configuration, the cross-linking of the coating resin can be interrupted by stopping the exposure of the sample to UV light, if the cross-linking is induced by exposure to UV light.

According to a further embodiment of the present invention, a method for forming a photovoltaic module comprising a backsheet and an encapsulant according to claim 2 is provided.

This solution is advantageous because it is possible to optimize the photovoltaic module production process, decreasing its cost and production times. In fact, the cross-linking process of the coating resin is divided into two sub-steps carried out at two successive times in the photovoltaic module production process: a first sub-step of partial cross-linking takes place in the ovens of the deposition and coating line, and a second sub-step of completion of the cross-linking takes place during the lamination of the resin to the photovoltaic module encapsulant. In fact, during the lamination step, the backsheet is necessarily exposed to high temperatures needed to laminate the layer of coating resin to the photovoltaic module encapsulant. Hence, the present invention is based on the idea of completing the cross-linking of the resin during the exposure of the resin to the high temperatures of the lamination process, thus realizing an intermediate film comprising a partially cross-linked resin layer to be attached to the photovoltaic modules. Since the cross-linking of the resin layer of the intermediate film is completed during the lamination of the intermediate film itself to the other layers of the photovoltaic module, the photovoltaic module in its final configuration after lamination includes the fully cross-linked resin layer and thus possesses the same properties, e.g., solvent resistance, as standard photovoltaic modules.

According to a preferred configuration, the substrate film may include a PET film, for example, a film consisting of one or two layers of PET. The function of the PET film is to provide electrical insulation for the photovoltaic module and to protect the solar cells from weathering at the rear. Preferably, a white bi-oriented PET film with high hydrolysis and UV resistance is used.

According to a preferred configuration, between step c) of partial cross-linking and step e) of lamination of the intermediate film to the encapsulant, the application of the intermediate film to the other layers of the photovoltaic module is carried out, for example to the encapsulant and the top layer, so that lamination of the photovoltaic module can be carried out later.

According to a further embodiment of the present invention, a method is provided, wherein the coating resin comprises a blocked cross-linking agent having an unblocking temperature and capable of inducing partial cross-linking of the layer of coating resin upon exposure to a temperature equal to or higher than the unblocking temperature.

The advantage of this configuration is that, due to the use of a blocked cross-linking agent, the cross-linking of the resin is induced by exposure to high temperatures and thus can be accomplished, in a controlled manner, within the ovens of the coating line. It can then be interrupted when the intermediate film leaves the ovens and is thus placed at room temperature, and can finally be completed when the intermediate film is laminated to the encapsulant in the laminating ovens.

It is to be understood that a blocked cross-linking agent indicates a reagent capable of helping cross-linking of the resin, wherein the reagent is inactive or blocked at temperatures below the unblocking temperature.

According to a further embodiment of the present invention, a method is provided, wherein the blocked cross-linking agent is a blocked aliphatic isocyanate.

The advantage of this configuration is that the blocked isocyanates include isocyanates with blocking agents as additives, which release the NCO bond only when the unblocking temperature is exceeded. This feature allows the use of very reactive isocyanates, but avoids the risk that they will induce cross-linking of the resin already at room temperature. In fact, if very reactive isocyanates were used without blocking agents, there would be a risk that the resin would cross-link immediately after mixing the two substances, even before it was spread on the substrate film. Therefore, the use of blocked isocyanates makes it possible to lengthen the workability time of the mixture, because the cross-linking reaction is blocked until the blocked isocyanate exceeds the unblocking temperature.

According to a preferred embodiment of the present invention, the blocked cross-linking agent has an unblocking temperature in the range of 100°C to 120°C, preferably 110°C.

According to an illustrative and non-limiting configuration, the blocked cross-linking agent may include di-ethyl-malonate (DEM) blocking agent. For example, blocked aliphatic isocyanate may be BI 7963, in which di-ethyl-malonate (DEM) blocking agent is used. The di-ethyl-malonate blocking agent is unblocked at an unblocking temperature of about 110°C. This configuration is advantageous because this unblocking temperature is suitable for the vacuum lamination process of a photovoltaic module. Moreover, the advantage of using a blocked cross-linking agent with a low unblocking temperature is that it completes the cross-linking process in a shorter time.

According to a further illustrative and non-limiting configuration, di-methyl-pyrazole (DMP), having an unblocking temperature of about 124°C, and/or methyl ethyl ketoxime (MEKO), having an unblocking temperature of about 165°C, can be used as blocking agents.

According to an alternative configuration, the blocked cross-linking agent can be, for example, blocked aromatic isocyanate, blocked aliphatic hybrid isocyanate and/or blocked water-base isocyanate.

According to a preferred embodiment of the present invention, the coating resin includes a cross-linking agent, and the entire cross-linking agent is blocked by a blocking agent. In other words, the entire amount of cross-linking agent is a blocked cross-linking agent.

According to a further embodiment of the present invention, a method is provided, wherein the partial cross-linking of step c) is stopped after a time interval comprised between 10 seconds and 25 seconds, preferably between 15 seconds and 20 seconds.

The advantage of this configuration is that the cross-linking process of the coating resin is interrupted before it is finished and is completed during the subsequent lamination step of the intermediate film to the photovoltaic module. Since the lamination step must necessarily be carried out in order to form the photovoltaic module and since, during lamination, the resin film is necessarily exposed to temperatures above the cross-linking agent unblocking tenperature, the resin cross-linking process is completed during lamination.

Preferably, the cross-linking of the coating resin is stopped when the resin is of such a consistency that it is dry and no longer wet, so that the intermediate film can be handled without deforming or damaging the layer of coating resin, but before it is completed. The expected time for completion of the cross-linking reaction is estimated, for example, by means of calorimetry measurements.

According to a preferred configuration, the cross-linking of the coating resin can be interrupted by stopping the heating process of the sample, if the cross-linking is induced by increasing temperature. According to a preferred configuration, the cross-linking of the coating resin can be stopped by stopping the exposure of the sample to UV light, if the cross-linking is induced by exposure to UV light.

According to the present invention, a method is provided, wherein partial cross-linking is carried out until an intermediate film comprising a partially cross-linked resin layer is obtained, wherein the cross-linking percentage is between 30% and 70%, preferably between 35% and 40%.

The advantage of this configuration is that the intermediate film is produced in a fast way, because there is no need to complete the entire cross-linking process. Moreover, these cross-linking levels can be already obtained during the step of solvent evaporation, and there is no need to wait any longer after solvent evaporation to form the intermediate film.

The percentage of partial cross-linking achieved can be influenced by several factors, such as the thickness of the layer of coating resin and/or the composition of the resin, for example, the amount of solvent and/or pigments and/or additives included in the resin.

According to a preferred configuration, partial cross-linking is carried out until an intermediate film comprising a partially cross-linked resin layer is obtained, wherein the cross-linking percentage is between 35% and 40%. Preferably, the thickness of the layer of coating resin is about 10 µm. The solvent percentage can be in the range of 55% to 75% by weight of the mixture.

The cross-linking percentage of the resin can be measured by performing an isothermal Differential Scanning Calorimetry (DSC) analysis.

According to a further embodiment of the present invention, a method is provided, wherein the step c) of partial cross-linking occurs by exposure of the intermediate film to a temperature in the range between 100° and 150° C.

The advantage of this configuration is that the exposure temperatures allow the cross-linking reaction to be triggered, for example by releasing the NCO group in the blocked cross-linking agent, thus immediately cross-linking the layer of coating resin. In addition, the exposure temperatures simultaneously allow the solvent contained in the liquid resin preparation to evaporate, if the resin is solvent-based, thus optimizing the entire production process of the intermediate film.

According to a further embodiment of the present invention, a method is provided, wherein the coating resin comprises an acrylic resin with acrylate functionality.

The advantage of using this resin is that it provides excellent adhesion to both the substrate film, e.g., PET substrate, and the encapsulant. Excellent adhesion is ensured not only at the initial time of application, but also after rapid aging tests.

According to a further embodiment of the present invention, a method is provided, wherein the substrate film is activated by means of a surface treatment, for example, a corona treatment, a plasma treatment, and/or a chemical etching treatment, prior to the step b), so as to facilitate the adhesion of the layer of coating resin to the substrate film.

The advantage of this configuration is that the adhesion of the resin layer to the substrate film, e.g., polyester film, is facilitated. This treatment allows the resin layer to have excellent adhesion to the substrate film even after aging tests, so that delamination of the module is avoided.

Chemical etching treatment (TCA) is a method for treating the surface of polyester to improve its adhesion to the surface of a subsequently applied coating. The method consists in applying a uniform layer of finely divided adherent silica particles, wherein the particles are applied to the surface with a solvent dispersion of silica particles containing a wetting agent and chlorine-substituted organic acids, such as trichloroacetic acid. Preferably, during a TCA treatment, an amount equal to about 10 µL of solution is applied to the polyester film, e.g. PET; then, the PET film and the coating layer are heated in processing ovens to evaporate the water and thus obtain a 1 µm-thick layer of trichloroacetic acid on the film. In the processing ovens, trichloroacetic acid decomposes into chloroform (CHCl3), which is not miscible with water and has a higher density and thus tends to stratify under the water layer during the evaporation process. Preferably, at the end of the TCA treatment, an outer layer of about 1 µm of the PET film is dissolved in the chlorinated solvent. In this way, the pyrogenic silica initially dispersed in the trichloroacetic acid can penetrate within the polymer matrix of the PET film, thereby becoming trapped in the film and creating silica agglomerates deeply embedded in the surface of the treated film. Preferably, such silica clusters have dimensions in the range of micrometer. Due to the structure of the PET film surface after the etching process, a better adhesion of any coating or adhesive layer subsequently applied to the TCA-treated PET film is achieved.

According to a further embodiment of the present invention, a method is provided, wherein the layer of coating resin includes pigments capable of absorbing visible light and transparent to infrared (IR) rays, for example, perylene-based pigments, such as BASF sicopal L 0086, Lumogen^{®} Black K 0087, Lumogen^{®} Black K 0088 and/or Paliogen^{®} Black S 0084.

The advantage of this configuration is that the intermediate film and/or photovoltaic module are pleasing to the eye and match the design of the buildings on which they are placed, while maintaining high energy efficiency. In fact, pigments capable of absorbing visible light, e.g., black pigments, give the photovoltaic module an excellent aesthetic design, but at the same time they cause an increase in temperature, resulting in a reduction in energy efficiency. The presence of pigments transparent to IR (the main cause of photovoltaic module heating) thus allows IR rays to pass through the layer of coating resin and enables the IR rays to reach the substrate film, which, in turn, reflects them. In this way, the IR rays are scattered and an increase in the temperature of the solar cells, which would cause a decrease in the energy efficiency of the module, is avoided. Preferably, the substrate film can be a white-colored PET film.

Preferably, different types of pigments such as titanium dioxide or organic pigments such as Spectrasense^{™} Black L 0086 can be added within the resin. The amount of pigments may vary depending on the opacity you wish to impart to the layer of coating resin.

According to a further embodiment of the present invention, a method is provided, wherein the layer of coating resin includes a solvent to enable workability of the coating resin mixture, for example, methyl-ethyl-ketone (MEK) and/or ethyl acetate, and the method further includes the following step:
f) evaporation of the solvent, for example by exposing the resin to a temperature between 100° and 150°C,
wherein step c) occurs during step f).

The advantage of this configuration is that the addition of a solvent to the coating resin allows for improved workability of the resin mixture. Preferably, partial cross-linking of the resin occurs during evaporation of the solvent contained in the resin, and thus the process of producing the intermediate film is optimized and speeded up. Preferably, evaporation of the solvent occurs by exposure of the resin to a temperature between 120°C and 130°C in drying ovens.

According to a preferred configuration, methyl-ethyl-ketone and/or ethyl acetate are used as solvents. The percentage of solvent can vary depending on several factors, such as the percentage of pigments used: if there is a large amount of pigments within the resin, it is indeed necessary to increase the percentage of solvent to allow the mixture to be workable. Preferably, the percentage of solvent is between 55% and 75% by weight of the mixture.

According to a further embodiment of the present invention, a method is provided, wherein partial cross-linking occurs by means of UV activation.

The advantage of this configuration is that the cross-linking process is further optimized and speeded up because cross-linking by UV activation occurs almost instantaneously following UV exposure.

According to a preferred configuration, partial cross-linking can itself be divided into two sub-steps, a first sub-step of temperature-induced partial cross-linking and a second sub-step of UV-induced partial cross-linking. Preferably, the liquid preparation of the resin includes both a blocked cross-linking agent and a photoinitiator. Thus, when the resin is exposed to temperatures above the unblocking temperature of the blocked cross-linking agent, cross-linking of a portion of the overlay layer is induced; the percentage of cross-linked portion of the resin is preferably adjusted by varying the exposure time to the high temperatures. When the resin is exposed to UV light, cross-linking of an additional portion of the resin layer is induced. Preferably, the exposure times to high temperatures and/or to UV are short, so that the partial cross-linking process is fast and not the entire layer of coating resin cross-links.

Non-limiting examples of photo-initiators that may be used in the present invention are Omnirad TPO-L, 2-hydroxy-2-methyl-1-phenylpropanone, diphenyl-2,4,6-trimethylbenzoyl phosphinoxide (TPO), phenyl bis-(2,4,6-trimethylbenzoyl) phosphine oxide (BAPO), 1-hydroxy cyclohexyl phenyl ketone (HCPK), 2-hydroxy-2-methyl-1-phenyl-1-propanone (HMPP), or the photo-initiators belonging to the class of bi-acyl phosphinoxide polymers (TPO), or the photo-initiators belonging to the class of alpha hydroxy ketones.

According to a further embodiment of the present invention, a method like those described above is provided, wherein the method is carried out according to a "reel-to-reel" process. In this way, it is possible to obtain the intermediate film wound in a reel.

The advantage of this configuration is that the production of the intermediate sheets and/or photovoltaic modules is done quickly and efficiently.

According to a further embodiment of the present invention, a method is provided, wherein the step e) of lamination occurs by exposing the intermediate film to a temperature in the range between 140°C and 170°C, preferably between 140°C and 160°C. The advantage of this configuration is that the adhesion between the resin of the intermediate film and the encapsulant of the photovoltaic module is facilitated and, at the same time, the cross-linking of the intermediate film resin is completed, since the temperatures achieved in the lamination step are higher than the unblocking temperature required to trigger the cross-linking reaction. Preferably, lamination of the partially cross-linked resin layer of the intermediate film to the encapsulant is carried out at 150°C for at least 10 min.

According to a further embodiment of the present invention, a method is provided, wherein the step b) takes place along a coating line and the step c) of partial cross-linking takes place along said coating line.

The advantage of this configuration is that it speeds up production time, since the coating resin is partially cross-linked directly down the coating line, without the need for additional processing.

According to a further embodiment of the present invention, a photovoltaic module including an encapsulant and a backsheet according to claim 13 is provided.

This solution is advantageous because an intermediate structure comprising a substrate film covered with a partially cross-linked resin is provided, which can be used at a later stage to form backsheets for photovoltaic modules. Since the cross-linking process is stopped before its completion, that is, before cross-linking of the entire resin layer is achieved, the intermediate film is made faster than the final backsheet with the fully cross-linked resin. In this way, costs and production times are saved. The cross-linking of the resin layer of the intermediate film is subsequently completed during the lamination of the intermediate film itself to the other layers of the photovoltaic module, so the photovoltaic module in the final configuration, after lamination, includes the fully cross-linked resin layer and thus has the same properties as standard photovoltaic modules.

According to a preferred configuration, the substrate film may include a PET film, for example, a film consisting of one or two layers of PET. The function of the PET film is to provide electrical insulation for the photovoltaic module and to protect the solar cells from weathering at the rear. Preferably, a white-colored bi-oriented PET film with high hydrolysis and UV resistance is used.

According to a preferred configuration, the cross-linking of the resin layer can be interrupted before it is completed by reducing the dwell time of the intermediate film in the ovens of the coating line to a temperature higher than the unblocking temperature of the blocked cross-linking agent. Preferably, cross-linking of the coating resin is stopped when the resin has reached a consistency that is hard and resistant to the touch, but before the cross-linking process has been fully completed. The intermediate film can then be advantageously wound and stored in reels, since the resin layer is sufficiently cross-linked, so that it is not sticky. According to an alternative configuration, the cross-linking of the resin layer can be stopped before it is completed by reducing the exposure time of the intermediate film to UV light.

According to the present invention, an intermediate film is provided wherein the percentage of cross-linked resin in the layer of coating resin is between 30% and 70%, preferably between 35% and 40%.

The advantage of this configuration is that the intermediate film is produced in a fast way, because there is no need to complete the entire cross-linking process. In addition, these cross-linking levels can be already obtained during the solvent evaporation step, so there is no need to wait for additional time after solvent evaporation to form the intermediate film.

The percentage of partial cross-linking achieved can be influenced by several factors, such as the thickness of the layer of coating resin, the resin grammage, and the composition of the resin, for example, the amount of solvent and/or pigments and/or additives included in the resin.

For example, the cross-linking percentage can be measured by performing an isothermal Differential Scanning Calorimetry (DSC) analysis.

According to a preferred configuration, the intermediate film includes a partially cross-linked resin layer, wherein the cross-linking percentage is in the range between 35% and 40%. Preferably, the thickness of the layer of coating resin is about 10 µm. For example, the solvent percentage can be in the range between 55% and 75% by weight of the mixture.

According to a further embodiment of the present invention, an intermediate film for a backsheet for photovoltaic modules is provided, wherein the coating resin includes a blocked cross-linking agent having an unblocking temperature and is capable of inducing partial cross-linking of the coating resin during an initial exposure to a temperature equal to or higher than the unblocking temperature.

The advantage of this configuration is that, due to the use of a blocked cross-linking agent, the cross-linking of the resin is induced by exposure to high temperatures and thus can be accomplished, in a controlled manner, within the ovens of the coating line. It can then be interrupted when the intermediate film leaves the ovens and is thus at room temperature, and it can finally be completed when the intermediate film is laminated to the encapsulant in the laminating ovens.

It should be understood that a blocked cross-linking agent indicates a reagent capable of triggering cross-linking of the resin, wherein the reagent is inactive or blocked at temperatures below the unblocking temperature.

According to a further embodiment of the present invention, an intermediate film for a backsheet for photovoltaic modules is provided, wherein the blocked cross-linking agent includes a blocked aliphatic isocyanate.

The advantage of this configuration is that the blocked isocyanates include isocyanates that are additivated with blocking agents, which release the NCO bond only when the unblocking temperature is exceeded. This feature allows using much more reactive isocyanates, but it avoids the risk that they would induce cross-linking of the resin already at room temperature. In fact, if very reactive isocyanates without blocking agents were used, there would be a risk that the resin would cross-link immediately after mixing the two substances, before being spread on the substrate film.

According to an illustrative and non-limiting configuration, the blocked aliphatic isocyanate can be BI 7963, in which the blocking agent di-ethyl-malonate is used. The di-ethyl-malonate blocking agent is unblocked at an unblocking temperature of about 110°C.

According to a further embodiment of the present invention, an intermediate film for a backsheet for photovoltaic modules is provided, wherein the coating resin includes a UV cross-linking agent.

The advantage of using a UV cross-linking agent in the resin is that it optimizes and speeds up the cross-linking of the resin and it allows obtaining an intermediate film and/or backsheet that is particularly resistant to scratching and solvent exposure when compared with temperature cross-linking.

According to a preferred configuration, the liquid resin preparation includes both a blocked cross-linking agent and a photoinitiator. In this way, when the resin is exposed to temperatures higher than the unblocking temperature of the blocked cross-linking agent, cross-linking of a portion of the coating layer is induced; the percentage of the cross-linked portion of the resin is preferably adjusted by varying the exposure time to the high temperatures. When the resin is exposed to UV light, cross-linking of an additional portion of the resin layer is induced. Preferably, the exposure times to high temperatures and/or to UV are short, so that the partial cross-linking process is fast and not the entire layer of coating resin cross-links.

According to a further embodiment of the present invention, an intermediate film for a backsheet for photovoltaic modules is provided, wherein the coating resin includes an acrylic resin with acrylate functionality.

The advantage of this configuration is that this resin provides excellent adhesion to both the substrate film, e.g., PET substrate, and the encapsulant. Excellent adhesion is ensured not only at the initial time of application, but also after rapid aging tests.

According to a further embodiment of the present invention, an intermediate film for a backsheet for photovoltaic modules is provided, wherein the coating resin includes pigments capable of absorbing visible light and transparent to infrared (IR) rays, for example, perylene-based pigments, such as BASF sicopal L 0086, Lumogen^{®} Black K 0087, Lumogen^{®} Black K 0088 and/or Paliogen^{®} Black S 0084.

The advantage of this configuration is that the intermediate film and/or photovoltaic module are pleasing to the eye and match the design of the buildings to which they are applied, while maintaining high energy efficiency. In fact, pigments capable of absorbing visible light, e.g., black pigments, give the photovoltaic module an excellent aesthetic design, but at the same time cause an increase in temperature, resulting in a reduction in energy efficiency. The presence of pigments transparent to IR (the main cause of photovoltaic module heating) thus allows IR rays to pass through the layer of coating resin and allows the IR rays to reach the substrate film, which, in turn, reflects the incident radiation. In this way, the IR rays are scattered and an increase in the temperature of the solar cells, which would cause a decrease in the energy efficiency of the module, is avoided. Preferably, the substrate film can be a white-colored PET film.

Preferably, different types of pigments such as titanium dioxide or organic pigments such as Spectrasense^{™} Black L 0086 can be added within the resin. The amount of pigments may vary depending on the opacity you wish to impart to the layer of coating resin.

According to a further embodiment of the present invention, an intermediate film is provided for a backsheet for photovoltaic modules, wherein the intermediate film is wound on a reel.

The advantage of this configuration is that the intermediate film is wound and stored in a reel and thus forms a "stand-alone" film that can be supplied to the lines for the production of photovoltaic modules, where it is laminated to the photovoltaic module encapsulant in order to complete the cross-linking process. Since the intermediate film requires temperatures above 100°C to complete the cross-linking process, it is stable at room temperature even on time scales of months or years.

### BRIEF DESCRIPTION OF THE FIGURES

The present invention will be described with reference to the enclosed figures, wherein the same reference numbers and/or signs indicate the same and/or similar and/or corresponding parts of the system.
Figure 1 schematically shows the initial configuration of an intermediate film for a backsheet for photovoltaic modules, according to an embodiment of the present invention.
Figure 2 schematically shows a section of an intermediate film for a backsheet for photovoltaic modules, according to an embodiment of the present invention.
Figure 3 schematically shows a section of a backsheet for photovoltaic modules, according to an embodiment of the present invention.
Figure 4 schematically shows a section of a photovoltaic module, according to an embodiment of the present invention.
Figure 5 schematically shows a production line for producing photovoltaic modules, according to an embodiment of the present invention.
Figure 6 schematically shows a production line for producing photovoltaic modules, according to a further embodiment of the present invention.
Figure 7 shows a plot of a test performed to determine the time required for total cross-linking of the layer of coating resin, according to a further embodiment of the present invention.
Figure 8 shows a plot of a DSC isothermal analysis performed on a fully cross-linked reference sample, according to a further embodiment of the present invention.
Figure 9 shows a plot of a DSC isothermal analysis performed on a non-cross-linked reference sample, according to a further embodiment of the present invention.
Figure 10 shows a plot of a DSC isothermal analysis performed on a partially cross-linked reference sample, according to a further embodiment of the present invention.
Figure 11 shows plots obtained by an isothermal analysis in DSC for a fully cross-linked reference sample, a non-cross-linked reference sample, and a partially cross-linked reference sample, according to a further embodiment of the present invention.

### DESCRIPTION

In the following, the present invention is described with reference to particular embodiments, as disclosed in the enclosed drawing plates. However, the present invention is not limited to the particular embodiments described in the following description and detailed and depicted in the figures, but rather the embodiments described simply exemplify the various aspects of the present invention, the scope of which is defined by the claims. Further modifications and variations of the present invention will be clear to the skilled person.

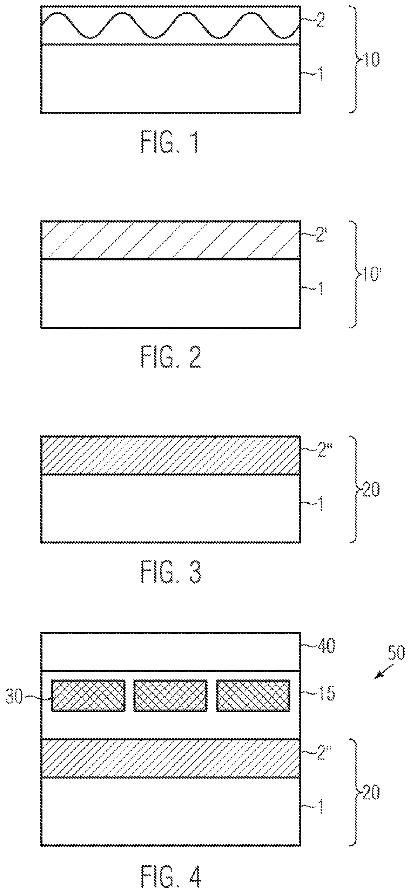

Figure 1 schematically shows the initial configuration of an intermediate film for a backsheet for photovoltaic modules, according to an embodiment of the present invention. The initial film 10 comprises a substrate film 1, for example a PET film, on which a layer of coating resin 2 is deposited and spread. For example, the layer of coating resin 2 may have a thickness between 5 µm and 15 µm, preferably of 10 µm.

Acrylic resin provides both good adhesion to PET and good adhesion to the encapsulant due to its functional groups.

Preferably, the resin 2 is a solvent-based resin, for example, with a solvent such as methyl-ethyl-ketone and/or ethyl acetate. The percentage of solvent may vary depending on several factors, such as the percentage of pigments used: in fact, if there is a large amount of pigments within the coating resin 2, the percentage of solvent must be increased to allow the mixture to be workable. Preferably, the percentage of solvent in the resin mixture is in the range between 55% and 75% by weight.

According to a preferred configuration, different types of pigments, such as titanium dioxide or organic pigments such as Spectrasense^{™} Black L 0086, can be added to the resin 2. The amount of pigments can vary according to the opacity desired for the coating. Preferably, dark pigments can be used, which can absorb light radiation and thus provide the product with an aesthetic appearance matching that of the buildings to which the finished photovoltaic module is applied. Preferably, dark pigments capable of letting IR radiation pass through are used: in this way, IR radiation passes through the layer of coating resin 2 and reaches the substrate 1, which reflects it, thus avoiding excessive overheating of the photovoltaic module and consequent expenditure of energy.

In order to facilitate the dispersion of pigments within the layer of coating resin and to avoid cluster formation, dispersants, for example Disperbyk 110, are preferably added to the resin 2.

Suitable filters can also be added to the resin 2 to improve the UV resistance. Preferably, an anti-blocking additive, e.g., deuteron wax PP, deuteron RMP, SYLOID ED 2, SYLOID ED 3, and/or SYLOID ED 5, is also added to the resin 2, in order to improve the slipperiness of the intermediate film 10' and to prevent that the intermediate film 10', wound on a reel, snaggs, but without affecting the adhesion properties of the layer of coating resin 2.

In the initial film 10, the resin 2 is in a liquid-viscous phase, for example, it can have a viscosity value between 40 Cps and 180 Cps, depending on the amount of solvent and pigments included in the mixture. The presence of cross-linking substances within the resin facilitates cross-linking of the resin layer by means of heating and/or by UV radiation. In fact, acrylic resin can be compatible with both thermal and UV cross-linking agents.

Preferably, cross-linking agents of the blocked aliphatic isocyanate type are used, such as BI 7963, which uses the blocking agent di-ethyl-malonate. These isocyanates are additivated with blocking agents, which release the NCO bond necessary to initiate the cross-linking reaction only when the unblocking temperature is exceeded. For example, the unblocking temperature of the blocking agent di-ethyl-malonate is about 110°C. This feature allows using very reactive isocyanates, without the risk of starting the cross-linking reaction already at room temperature. In fact, if a very reactive isocyanate without blocking agents were used, there would be a risk of starting the cross-linking of the resin immediately after mixing the two components, even before the resin 2 is spread on the substrate 1.

By adding the blocked isocyanates within the resin, it is possible to divide the cross-linking process into two distinct steps, a first step of evaporation of the resin solvents and a second step of lamination of the module.

Figure 2 schematically shows an intermediate film 10', in which the layer of coating resin 2' is partially cross-linked, that is, not the entire layer of coating resin 2' has been cross-linked, but only part of it.

Cross-linking of the resin 2 starts inside the ovens of the coating line, where high temperatures, for example between 100°C and 150°C, cause the solvent to evaporate and unblock the blocked isocyanate, thus releasing the NCO bond. As soon as the NCO functional group is released, it reacts with the resin, cross-linking it. By using a highly reactive isocyanate, the cross-linking process occurs almost instantaneously.

However, the initial film 10 remains in the ovens of the coating line for a time interval comprised between 10 seconds and 25 seconds, preferably between 15 seconds and 20 seconds, and this dwell time in the ovens is not sufficient to release all of the isocyanate cross-linking agent and to complete cross-linking. For this reason, at the end of the coating step, an intermediate film 10' is obtained, which includes a substrate film 1, for example PET, and a layer of partially cross-linked resin 2'.

The cross-linking of the resin is completed at a later stage of the production process of the photovoltaic module, namely during the lamination step of the intermediate film 10' to the encapsulant 15 of the photovoltaic module. In fact, during the lamination step of the photovoltaic module 50, the intermediate film 10' is exposed to high temperatures, e.g. equal to 150°C, and the blocked isocyanate is then reactivated and the cross-linking process of the partially cross-linked resin 2' is completed. During this step, the resin 2' cross-links simultaneously with the encapsulant 15', thus ensuring greater possibility of welding the two components.

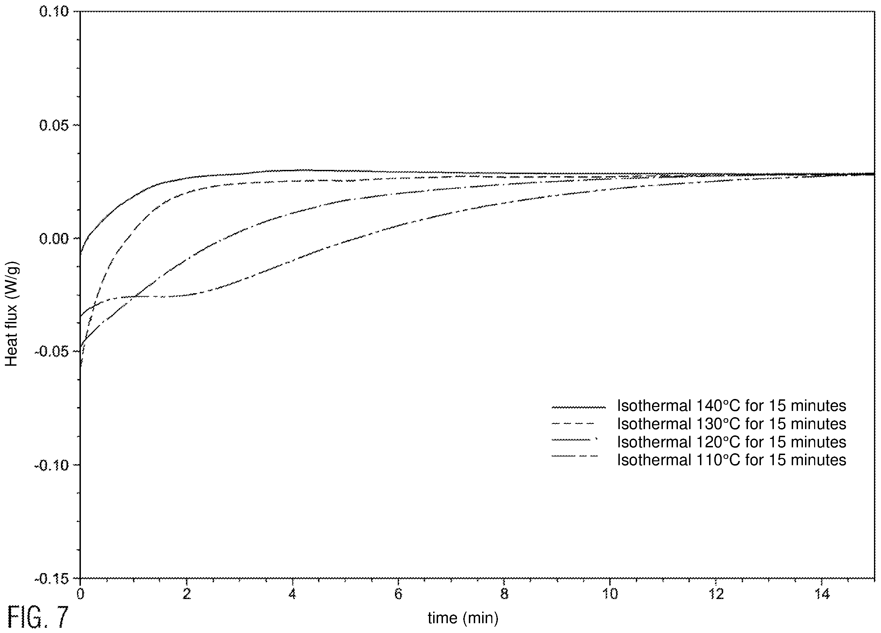

The method for estimating the partial and total cross-linking times of the resin is described below in relation to Figure 7.

At the end of the lamination process, a backsheet 20 is then obtained, the backsheet 20 comprising a substrate film 1 and a layer of fully cross-linked resin 2" (see Figure 3): the same properties as those of standard backsheets are hence ensured. According to the above-described process, the backsheet 20 does not form a stand-alone film, but it is formed already laminated to the photovoltaic module 50.

Figure 4 schematically shows a section of a photovoltaic module 50, according to an embodiment of the present invention. The photovoltaic module 50 includes, from bottom to top, the backsheet 20 with the PET substrate 1 and the fully cross-linked resin 2" that acts as an adhesive between the backsheet 20 and the encapsulant 15. Inside the encapsulant 15, the solar cells 30 are formed. The photovoltaic module 50 also includes a top layer 40 of glass or thermoplastic materials, which covers the sun-exposed surface of the module 50 and allows sunlight to reach the cells 30.

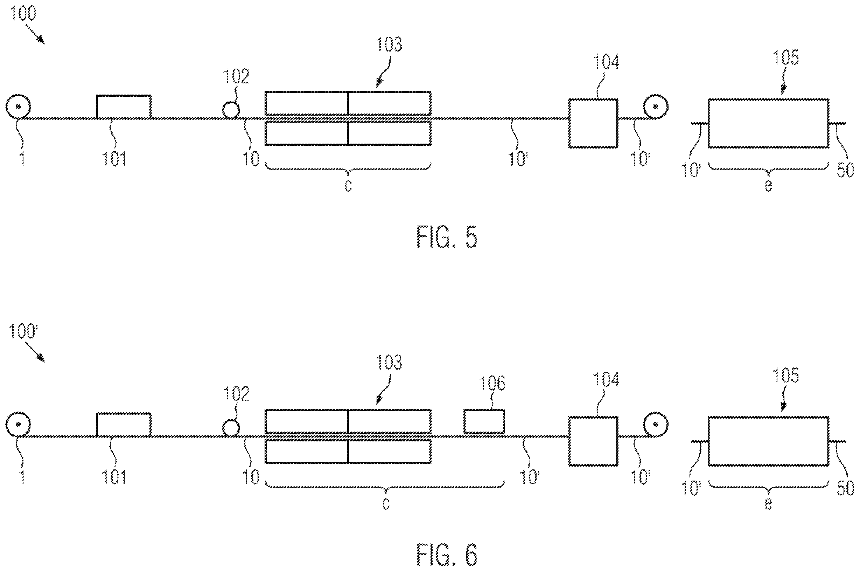

Figure 5 schematically shows a production line 100 for photovoltaic modules, according to a preferred embodiment of the present invention.

The production line 100 is preferably organized in the "reel-to-reel" mode: the substrate film 1, for example a PET film, is initially wound into a reel, it is progressively unwound to pass through the production stations for the formation of the layer of coating resin 2', and finally the intermediate 10' film comprising the substrate 1 and the coating resin 2' is wound again into a reel.

The substrate film 1 is initially exposed to a surface treatment at station 101, in order to improve the adhesion of the layer of coating resin 2: for example, it is exposed to a corona discharge treatment, a plasma discharge treatment, and/or a chemical attack treatment.

At a later stage, the substrate film 1 passes through station 102, where deposition of the liquid mixture of the coating resin 2 takes place, at room temperature. The liquid mixture of the coating layer includes an acrylic resin with acrylate functionality, a solvent such as methyl-ethyl-ketone or ethyl-acetate, and a blocked cross-linking agent, for example, a blocked aliphatic isocyanate. Preferably, the liquid mixture may include an anti-blocking additive to improve film slipperiness and to prevent reel packing in the final step, for example deuteron wax PP, deuteron RMP, SYLOID ED 2, SYLOID ED 3 and/or SYLOID ED 5. In addition, the liquid mixture may include pigments such as titanium dioxide or Spectrasense^{™} Black L 0086 to increase the opacity of the coating layer, a dispersing additive such as Disperbyk 110, and/or filters to improve UV resistance, such as tinuvin 1130.

The film 10 comprising the substrate film 1 covered by the layer of coating resin 2 in the liquid-viscous step then passes through station 103, where there are ovens set at a temperature between 100°C and 150°C, preferably at a temperature between 120°C and 130°C, in order to evaporate the solvent contained in the liquid mixture. Preferably, the dwell time of the film 10 comprising the substrate film 1 covered by the resin layer 2 in the ovens 103 is in the range of 10 seconds to 25 seconds, preferably 15 seconds to 20 seconds. Exposure of the resin to solvent evaporation temperatures also triggers the cross-linking of the resin. However, the exposure times employed allow the resin 2 to cross-link only partially. When the intermediate 10' film comes out of the ovens, the resin 2' is in fact not fully cross-linked, but it has reached a degree of cross-linking such that the film 10' can be easily handled and for example, it can be wound into reels, without risk of the different layers of the reels to stick together. Preferably, the film 10' includes a resin layer with a cross-linking percentage between 35% and 40%.

At station 103, solvent evaporation and partial cross-linking of the resin (step c)of partial cross-linking) occur simultaneously, thus resulting in an intermediate film 10' (precursor to the backsheet 20) comprising a substrate film 1 and a layer of partially cross-linked coating resin 2'.

The intermediate film 10' is then wound onto reels at room temperature and trimmed, and then transferred to the forming stations for producing photovoltaic modules. Since the intermediate film 10' requires temperatures above 100°C to complete the cross-linking process, it is stable at room temperature even on time scales of months or years.

At station 105, the photovoltaic module 50 is formed. Initially, the components of the photovoltaic module 50 are arranged on top of each other, as schematically shown in Figure 4, and then the module enters a chamber where it is heated and laminated. In particular, at this stage, the intermediate film 10' is laminated to the encapsulant 15 to form the photovoltaic module 50. Lamination is achieved by adhering the intermediate film 10' to the encapsulant 15 by means of heating. Heating can be carried out at increased or reduced pressure (such as vacuum lamination) and, for example, it involves exposing the photovoltaic module 50 to a temperature of 150°C for at least 10 minutes. During lamination, exposure of the resin to temperatures above the unblocking temperature of the blocked cross-linking agent induces a second cross-linking reaction (step e) of total cross-linking), which leads to complete cross-linking of the coating resin 2'. Hence, when it leaves station 105, the photovoltaic module 50 comprises a fully formed backsheet 20, i.e., comprising a fully cross-linked substrate film 1 and a fully cross-linked 2" layer of coating resin.

Figure 6 schematically shows a production line 100' for photovoltaic modules, according to an alternative embodiment of the present invention.

The production line 100' includes all the stations of the production line 100 and it also includes a station 106 comprising UV lamps, located downstream of station 103.

According to this alternative embodiment, a UV cross-linking agent is added into the liquid mixture of the coating layer, which is activated by UV exposure and can induce cross-linking of the resin 2. In this way, the step c) of partial cross-linking can be divided in turn into two sub-steps: a first step of temperature-induced partial cross-linking and a second step of UV-induced partial cross-linking. The first partial cross-linking can take place by conveying the substrate film 1 with the layer of coating resin 2 in the ovens 103, as in production line 100, but the dwell times of the film in the ovens 103 can be further reduced, since it is possible to cross-link a lower percentage of coating resin. In the next step, the film 10' may pass through station 106, where it is exposed to UV radiation, and cross-linking of an additional portion of the coating layer can be induced.

When it comes out of station 106, the intermediate film 10' is partially cross-linked, i.e., the coating layer 2' is not fully cross-linked, but has a consistency that allows it to be handled and wound onto reels.

Figure 7 shows a plot obtained by Differential Scanning Calorimetry (DSC) isothermal analysis, which is performed to determine the time required to achieve total cross-linking of the coating resin.

During each cycle of DSC measurements, the sample is kept at a constant temperature and the variation in heat flux over time is measured. In this way, temperature changes in the test sample, due to endothermic and/or exothermic reactions occurring within the material, can be estimated.

Tests were carried out on a sample including a layer of resin spread on a silicon paper substrate, which was subsequently removed. The analysis was then performed only on the resin sample. The resin in the sample has the same chemical composition as the resin of the coating layer 2 used to produce the intermediate film 10' and it includes a blocked isocyanate. Before performing isothermal analysis in DSC, the sample was left in an oven at 50°C for 24 h to allow the solvent contained in the resin to evaporate (in fact, the presence of solvents within the mixture may interfere with the DSC analysis).

The tests were carried out by keeping the sample at a constant temperature of 110°C, 120°C, 130°C and 140°C, respectively. The results of the isothermal analysis in DSC are shown in Figure 7.

As it can be seen from the plot in Figure 7, after a time interval of reaction time, each isotherm curve reaches a constant limit value, which indicates the completion of the cross-linking reaction, as it indicates that no more endothermic and/or exothermic reactions are occurring within the sample. As the temperature at which the resin is kept increases, the time required to complete the cross-linking decreases.

Based on these data, the inventors estimated the times required to complete the cross-linking of the resin to be 14 min at 110°C, 12 min at 120°C, 7 min at 130°C and 2 min at 140°C, respectively. Therefore, they concluded from this evidence that, if the resin is kept at the temperatures of 110°C, 120°C, 130°C and 140°C for less than 14 min, 12 min, 7 min and 2 min, respectively, then the cross-linking of the resin is not completed, but only part of the resin is cross-linked. Therefore, they estimated that it is convenient to keep the initial film 10 in the ovens of station 103 for a time interval comprised between 10 seconds and 25 seconds, preferably between 15 seconds and 20 seconds, at a temperature between 100°C and 150°C, preferably between 120°C and 130°C, i.e. higher than the unblocking temperature of the blocked cross-linking agent. This induces partial cross-linking of the resin 2, which can be completed in the ovens at station 105, where exposure to temperatures of at least 150°C for a time of at least 10 min is sufficient to complete the cross-linking reaction.

The plot shown in Figure 7 can also be an indication for the user to estimate exposure temperatures and exposure times necessary for the intermediate film 10' to complete cross-linking of the resin, for example, to form photovoltaic modules.

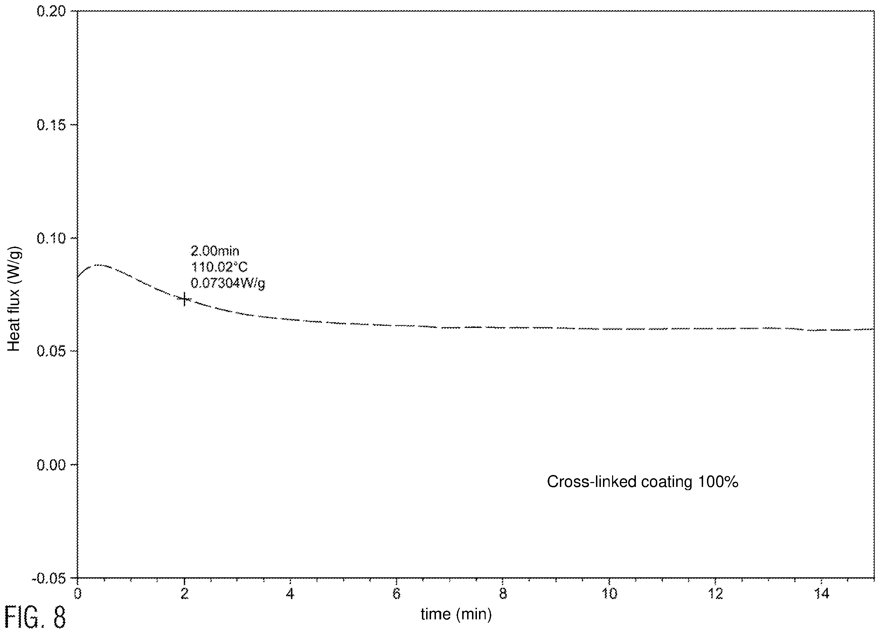

In the following, a possible method for estimating, in an indirect way, the cross-linking percentage of the layer of coating resin in a sample according to an embodiment of the present invention is described, with reference to Figures 8 to 11. This method is based on an isothermal analysis in DSC.

Tests were performed on several samples comprising a resin layer placed on a siliconized paper substrate, wherein the resin has the same chemical composition as the resin of the coating layer 2 used for the production of the intermediate sheets 10' and it comprises a blocked isocyanate. Prior to isothermal analysis in DSC, each sample was left in an oven at 50°C for 24 h to allow evaporation of the solvent contained in the resin (in fact, the presence of solvents within the mixture may interfere with the DSC analysis).

A first reference sample, prepared according to the method described, above was left in an oven at 150°C for 1 hour to obtain a sample with a 100% cross-linked resin layer (as also evident from the plot in Figure 7). A second reference sample, prepared in the manner described above, was not exposed to any heating process, so that the resin layer was not cross-linked (0% cross-linking).

Both samples were subjected to isothermal analysis in DSC at 110°C for 15 min, and heat flux was measured as a function of time.

Figure 8 shows the heat flow curve as a function of time at constant temperature (equal to 110°C) for the first fully cross-linked sample.

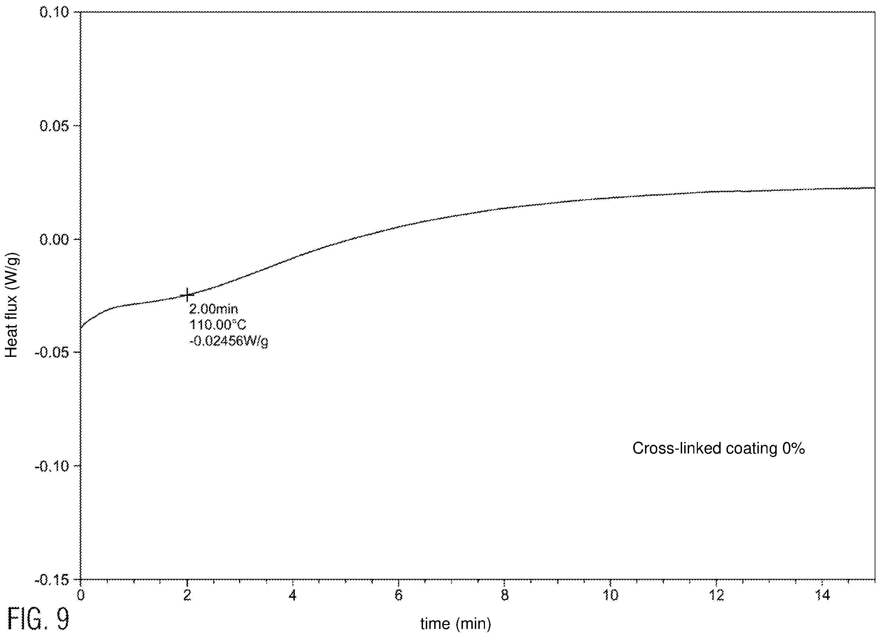

Figure 9 shows the heat flux curve as a function of time at constant temperature (equal to 110°C) for the second non-cross-linked sample.

As can be seen from Figs. 8 and 9, the two samples result in isotherm curves having different trends because they have different initial cross-linking percentages. In particular, the measured heat flux is related to the percentage of blocked isocyanate that is activated and thus to the percentage of cross-linked resin.

A third reference sample was prepared in the manner described above and was then left in an oven at 110°C for 15 seconds to induce partial cross-linking of the resin (as shown in the data in Figure 7). The value of the percentage of cross-linked resin is unknown and it represents the object of this analysis. The third sample was then subjected to isothermal analysis in DSC at 110°C for 15 minutes, and its heat flux was measured as a function of time.

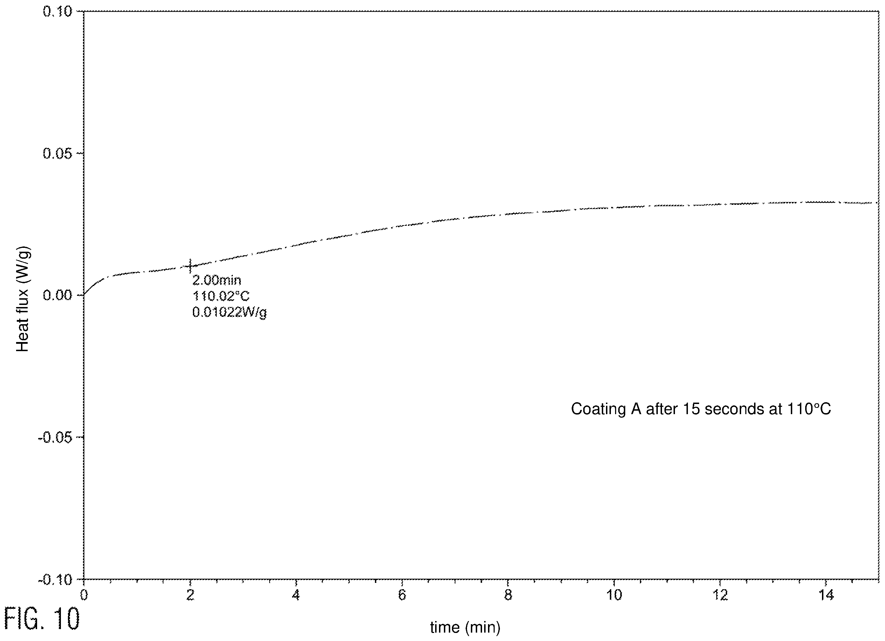

Figure 10 shows the heat flux curve as a function of time at constant temperature (equal to 110°C) for the third partially cross-linked sample.

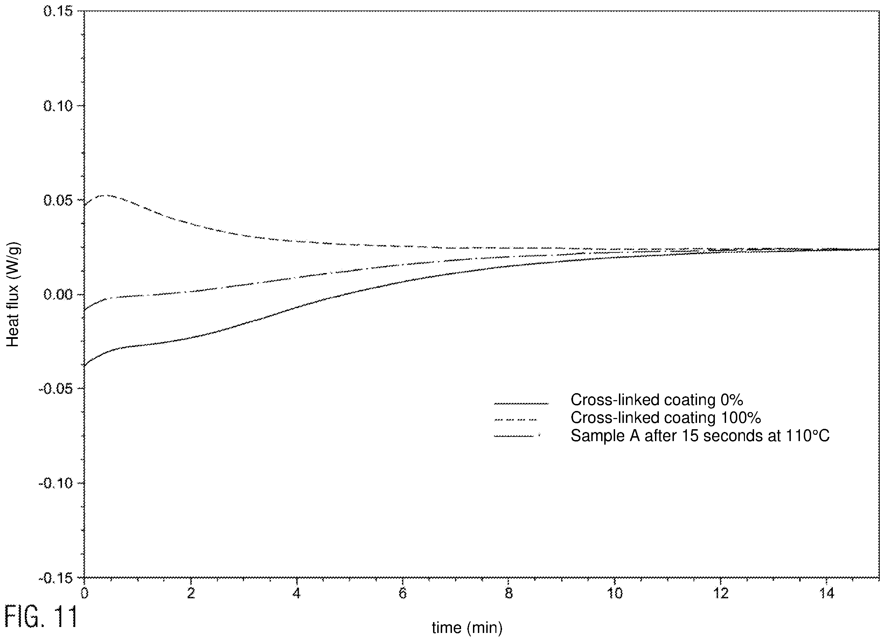

As can be seen from the comparison of Figures 8, 9 and 10, the isotherm curve of the third sample is different from that of the two reference samples because its cross-linking percentage is different from that of the two reference samples, and in particular it is higher than that of the second sample and lower than that of the first sample. For ease of reading, the three curves of heat flux versus time at constant temperature (equal to 110°C) of the first sample, the second sample and the third sample are compared and shown together in the plot in Figure 11.

To estimate the percentage of cross-linked resin in the third sample, the inventors compared the heat flux values for each curve after a time interval of 2 minutes (this time interval is indeed considered sufficient for the sample to stabilize in the DSC instrument). In particular, the heat flux value of the first sample at 2 minutes and the heat flux value of the third sample at 2 minutes are rescaled with respect to the heat flux value of the second sample at 2 minutes. As a next step, the ratio between the rescaled heat flux value of the third sample and the rescaled heat flux value of the first sample is calculated. This ratio represents an indirect way to estimate the percentage of cross-linked resin in the third sample relative with respect to the total.

In the case shown in Figure 8, the heat flux for the first sample after 2 minutes is 0.073 W/g. In the case shown in Figure 9, the heat flux for the second sample after 2 minutes is -0.025 W/g. In the case shown in Figure 10, the heat flux for the third sample after 2 minutes is 0.010 W/g. Therefore, in this case, the heat flux of the first sample rescaled with respect to the second sample after 2 minutes is 0.098 W/g; the heat flux of the third sample rescaled with respect to the second sample after 2 minutes is 0.035 W/g; the percentage of cross-linked resin in the third sample is hence about 35% of the total.

The method described in relation to Figures 8 to 11 is thus a possible method for estimating that the sample of interest is partially cross-linked. In particular, for example, the percentage of partial cross-linking of the resin is about 35% compared to the maximum value represented by the totally cross-linked reference sample.

Even if the present invention has been described with reference to the embodiments described above, it is clear to the person skilled in the art that various modifications, variations, and improvements of the present invention in light of the teachings described above and within the scope of the appended claims can be made without departing from the subject matter and scope of protection of the invention.

For example, although the use of a blocked cross-linking agent including a blocked aliphatic isocyanate is described, it is clear that other types of blocked cross-linking agents may be used, such as a blocked aromatic isocyanate, a blocked aliphatic hybrid isocyanate, and/or a blocked water-base isocyanate.

For example, although the use of di-ethyl-malonate (DEM) as a blocking agent has been described, it is clear that other types of blocking agents can be used, such as di-methyl-pyrazole (DMP) and/or methyl ethyl ketoxime (MEKO).

Moreover, it should be understood that any type of blocked cross-linking agent, e.g., blocked aliphatic isocyanate, blocked aromatic isocyanate, blocked aliphatic hybrid isocyanate, and/or blocked water-base isocyanate, can be advantageously used with any type of blocking agent, e.g., DEM, DMP, and/or MEKO.

Finally, those areas that are considered to be known to the skilled person have not been described to avoid unnecessarily overshadowing the described invention.

Accordingly, the invention is not limited to the embodiments described above, but it is only limited by the scope of protection of the appended claims.

## Claims

1. Method for forming an intermediate film (10') for a backsheet (20) for photovoltaic modules, said method comprising the following steps, performed in the order in which they are listed:
a) providing a substrate film (1), for example, a PET film;
b) depositing a layer of coating resin (2) on said substrate film (1);
c) partially cross-linking said layer of coating resin (2) by interrupting cross-linking after a predefined time interval less than the time for completing the cross-linking reaction so as to obtain an intermediate film (10') comprising said substrate film (1) covered by a layer of partially cross-linked resin (2'),
**characterized in that:**
the cross-linking percentage of said partially cross-linked resin (2') is comprised between 30% and 70%, even more preferably between 35% and 40%, wherein said cross-linking percentage of the resin is measured by performing an isothermal Differential Scanning Calorimetry (DSC) analysis.

2. Method for forming a photovoltaic module (50) including a backsheet (20) and an encapsulant (15), said method including the following steps, performed in the order in which they are listed:
a) providing a substrate film (1), for example, a PET film;
b) depositing a layer of coating resin (2) on said substrate film (1);
c) partially cross-linking said layer of coating resin (2), so as to obtain an intermediate film (10') comprising said substrate film (1) covered by a layer of partially cross-linked resin (2'), wherein the cross-linking percentage of said partially cross-linked resin (2') is comprised between 30% and 70%, even more preferably between 35% and 40%, wherein said cross-linking percentage of the resin is measured by performing an isothermal Differential Scanning Calorimetry (DSC) analysis;
e) laminating said intermediate film (10') to said encapsulant (15);
wherein, during said laminating step e), the completion of the cross-linking of said layer of partially cross-linked resin (2') takes place.

3. Method according to claim 2, wherein said step c) comprises an interruption of said partial cross-linking after a predefined time interval less than the time for completing the cross-linking reaction.

4. Method according to any one of the previous claims, wherein said coating resin (2) comprises a blocked cross-linking agent having an unblocking temperature and capable of inducing a partial cross-linking of said layer of coating resin (2) upon exposure to a temperature equal to or greater than said unblocking temperature, wherein said unblocking temperature is preferably comprised between 100°C and 120°C, more preferably equal to 110°C.

5. Method according to claim 4, where said blocked cross-linking agent includes the blocking agent di-ethyl-malonate (DEM) or a blocked aliphatic isocyanate.

6. Method according to any one of the previous claims, wherein said coating resin (2) comprises a cross-linking agent and all of said cross-linking agent is blocked by a blocking agent.

7. Method according to any one of the previous claims, wherein said partial cross-linking of said step c) is stopped after a time interval between 10 seconds and 25 seconds, preferably between 15 seconds and 20 seconds.

8. Method according to any one of the previous claims, wherein said layer of coating resin (2) comprises a solvent to enable workability of the mixture of said coating resin (2), for example methyl-ethyl-ketone and/or ethyl acetate, and said method further comprises the following step:
f) evaporation of said solvent, for example by exposure of said resin to a temperature between 100° and 150°C,
where said step c) occurs during said step f).

9. Method according to any one of the previous claims, where said partial cross-linking occurs by means of UV activation.

10. Method according to any one of the previous claims, where said method is carried out by means of a reel-to-reel process.

11. Method according to claim 2 or according to any one of claims 3 to 10 when depending from claim 2, wherein said step e) of lamination occurs by means of exposure of said intermediate film (10') to a temperature in the range of 140°C to 170°C, preferably 140°C to 160°C.

12. Method according to any one of the previous claims, wherein said step b) is carried out along a coating line and said step c) of partial cross-linking is carried out along said coating line.

13. A photovoltaic module (50) comprising an encapsulant (15) and a backsheet (20), wherein said photovoltaic module (50) is produced by means of the method according to claim 2 or according to any one of claims 3 to 12 when dependent from claim 2.

14. An intermediate film (10') for a backsheet (20) for photovoltaic modules comprising the following layers:
- a substrate film (1), for example, a PET film;
- a layer of partially cross-linked coating resin (2');
**characterized in that**:
the percentage of cross-linked resin in said layer of partially cross-linked coating resin (2') is comprised between 30% and 70%, even more preferably between 35% and 40%, wherein said cross-linking percentage of the resin is measured by performing an isothermal Differential Scanning Calorimetry (DSC) analysis.

15. The intermediate film (10') according to claim 14, wherein said coating resin (2) comprises a cross-linking agent and all of said cross-linking agent is blocked by means of a blocking agent, wherein said cross-linking agent includes for instance a UV cross-linking agent.

16. The intermediate film (10') according to any one of claims 14 or 15, wherein said coating resin (2') includes an acrylic resin with acrylate functionality.

17. The intermediate film (10') according to any one of claims 14 to 16, wherein said coating resin (2') includes pigments capable of absorbing visible light and transparent to infrared (IR) light, for example, perylene-based pigments.

18. The intermediate film (10') according to any one of claims 14 to 17, wherein said intermediate film (10') is wound on a reel.

## Patentansprüche

1. Verfahren zur Herstellung eines Zwischenfilms (10') für eine Rückseitenfolie (20) für Photovoltaikmodule, wobei das Verfahren die folgenden Schritte umfasst, die in der Reihenfolge ausgeführt werden, in der sie aufgeführt sind:
a) Bereitstellung eines Substratfilms (1), zum Beispiel eines PET-Films;
b) Aufbringen einer Schicht aus Beschichtungsharz (2) auf den Substratfilm (1);
c) teilweises Vernetzen der Schicht aus Beschichtungsharz (2) durch Unterbrechen der Vernetzung nach einem vordefinierten Zeitintervall, das kürzer ist als die Zeit für den Abschluss der Vernetzungsreaktion, um einen Zwischenfilm (10') zu erhalten, der den Substratfilm (1) umfasst, der mit einer Schicht aus teilweise vernetztem Harz (2') bedeckt ist,
**dadurch gekennzeichnet, dass:**
der Vernetzungsprozentsatz des teilweise vernetzten Harzes (2') zwischen 30 % und 70 %, noch bevorzugter zwischen 35 % und 40 % liegt, wobei der Vernetzungsprozentsatz des Harzes durch Durchführung einer isothermen Differentialscanningkalorimetrie (DSC)-Analyse gemessen wird.

2. Verfahren zur Herstellung eines Photovoltaikmoduls (50), das eine Rückseitenfolie (20) und eine Verkapselung (15) umfasst, wobei das Verfahren die folgenden Schritte umfasst, die in der Reihenfolge ausgeführt werden, in der sie aufgeführt sind:
a) Bereitstellung eines Substratfilms (1), zum Beispiel eines PET-Films;
b) Aufbringen einer Schicht aus Beschichtungsharz (2) auf den Substratfilm (1);
c) teilweises Vernetzen der Schicht aus Beschichtungsharz (2), um einen Zwischenfilm (10') zu erhalten, der den Substratfilm (1) umfasst, der mit einer Schicht aus teilweise vernetztem Harz (2') bedeckt ist, wobei der Vernetzungsprozentsatz des teilweise vernetzten Harzes (2') zwischen 30 % und 70 %, noch bevorzugter zwischen 35 % und 40 % liegt, wobei der Vernetzungsprozentsatz des Harzes durch Durchführung einer isothermen Differentialscanningkalorimetrie (DSC)-Analyse gemessen wird;
e) Laminieren des Zwischenfilms (10') auf die Verkapselung (15);
wobei während des Laminierschritts e) die Vollendung der Vernetzung der Schicht aus teilweise vernetzten Harz (2') stattfindet.

3. Verfahren nach Anspruch 2, wobei der Schritt c) eine Unterbrechung der Teilvernetzung nach einem vordefinierten Zeitintervall umfasst, das kürzer ist als die Zeit für den Abschluss der Vernetzungsreaktion.

4. Verfahren nach einem der vorhergehenden Ansprüche, wobei das Beschichtungsharz (2) ein blockiertes Vernetzungsmittel umfasst, das eine Entblockungstemperatur aufweist und in der Lage ist, eine teilweise Vernetzung der Schicht des Beschichtungsharzes (2) zu induzieren, wenn es einer Temperatur ausgesetzt wird, die gleich oder höher als die Entblockungstemperatur ist, wobei die Entblockungstemperatur vorzugsweise zwischen 100°C und 120°C liegt, besonders bevorzugt gleich 110°C ist.

5. Verfahren nach Anspruch 4, wobei das blockierte Vernetzungsmittel das Blockierungsmittel Di-Ethyl-Malonat (DEM) oder ein blockiertes aliphatisches Isocyanat enthält.

6. Verfahren nach einem der vorhergehenden Ansprüche, wobei das Beschichtungsharz (2) ein Vernetzungsmittel enthält und das gesamte Vernetzungsmittel durch ein Blockierungsmittel blockiert ist.

7. Verfahren nach einem der vorhergehenden Ansprüche, wobei die Teilvernetzung des Schritts c) nach einem Zeitintervall zwischen 10 Sekunden und 25 Sekunden, vorzugsweise zwischen 15 Sekunden und 20 Sekunden, beendet wird.

8. Verfahren nach einem der vorhergehenden Ansprüche, wobei die Schicht des Beschichtungsharzes (2) ein Lösungsmittel enthält, um die Verarbeitbarkeit der Mischung des Beschichtungsharzes (2) zu ermöglichen, zum Beispiel Methyl-Ethyl-Keton und/oder Ethylacetat, und wobei das Verfahren ferner den folgenden Schritt umfasst:
f) Verdampfung des Lösungsmittels, zum Beispiel durch Aussetzen des Harzes einer Temperatur zwischen 100° und 150°C,
wobei der Schritt c) während des Schrittes f) erfolgt.

9. Verfahren nach einem der vorhergehenden Ansprüche, wobei die Teilvernetzung durch UV-Aktivierung erfolgt.

10. Verfahren nach einem der vorhergehenden Ansprüche, wobei das Verfahren mittels eines Rollezu-Rolle-Verfahrens durchgeführt wird.

11. Verfahren nach Anspruch 2 oder nach einem der Ansprüche 3 bis 10 in Abhängigkeit von Anspruch 2, wobei der Schritt e) des Laminierens dadurch erfolgt, dass der Zwischenfilm (10') einer Temperatur im Bereich von 140°C bis 170°C, vorzugsweise 140°C bis 160°C, ausgesetzt wird.

12. Verfahren nach einem der vorhergehenden Ansprüche, wobei der Schritt b) entlang einer Beschichtungslinie durchgeführt wird und der Schritt c) der teilweisen Vernetzung entlang der Beschichtungslinie durchgeführt wird.

13. Photovoltaikmodul (50), das eine Verkapselung (15) und eine Rückseitenfolie (20) umfasst, wobei das Photovoltaikmodul (50) mittels des Verfahrens nach Anspruch 2 oder nach einem der Ansprüche 3 bis 12 in Abhängigkeit von Anspruch 2 hergestellt wird.

14. Zwischenfilm (10') für eine Rückseitenfolie (20) für Photovoltaikmodule mit den folgenden Schichten:
- ein Substratfilm (1), z. B. eine PET-Folie;
- eine Schicht aus teilweise vernetztem Beschichtungsharz (2'); **dadurch gekennzeichnet, dass**:
der Prozentsatz des vernetzten Harzes in der Schicht aus teilweise vernetztem Beschichtungsharz (2') zwischen 30 % und 70 %, noch bevorzugter zwischen 35 % und 40 % liegt, wobei der Vernetzungsprozentsatz des Harzes durch Durchführung einer isothermen Differentialscanningkalorimetrie (DSC)-Analyse gemessen wird.

15. Zwischenfilm (10') nach Anspruch 14, wobei das Beschichtungsharz (2) ein Vernetzungsmittel umfasst und das gesamte Vernetzungsmittel mittels eines Blockierungsmittels blockiert ist, wobei das Vernetzungsmittel beispielsweise ein UV-Vernetzungsmittel umfasst.

16. Zwischenfilm (10') nach einem der Ansprüche 14 oder 15, wobei das Beschichtungsharz (2') ein Acrylharz mit Acrylatfunktionalität enthält.

17. Zwischenfilm (10') nach einem der Ansprüche 14 bis 16, wobei das Beschichtungsharz (2') Pigmente enthält, die sichtbares Licht absorbieren und für infrarotes (IR-)Licht transparent sind, z. B. Pigmente auf Perylenbasis.

18. Zwischenfilm (10') nach einem der Ansprüche 14 bis 17, wobei der Zwischenfilm (10') auf eine Spule aufgewickelt ist.

## Revendications

1. Procédé de formation d'un film intermédiaire (10') pour une feuille de fond (20) pour des modules photovoltaïques, ledit procédé comprenant les étapes suivantes, exécutées dans l'ordre dans lequel elles sont énumérées :
a) fourniture d'un film de substrat (1), par exemple, un film PET ;
b) dépôt d'une couche d'une résine de revêtement (2) sur ledit film de substrat (1) ;
c) réticulation partielle de ladite couche de résine de revêtement (2) en interrompant une réticulation après un intervalle de temps prédéfini inférieur à la durée d'exécution complète de la réaction de réticulation, de sorte à obtenir un film intermédiaire (10') comprenant ledit film de substrat (1) couvert d'une couche de résine partiellement réticulée (2'),
**caractérisé en ce que** :
le pourcentage de réticulation de ladite résine partiellement réticulée (2') est compris entre 30 % et 70 %, même plus préférablement entre 35 % et 40 %, dans lequel ledit pourcentage de réticulation de la résine est mesuré en procédant à une analyse calorimétrique par balayage différentiel, DSC (Differential Scanning Calorimetry), isotherme.

2. Procédé de formation d'un module photovoltaïque (50) incluant une feuille de fond (20) et un encapsulant (15), ledit procédé comprenant les étapes suivantes, exécutées dans l'ordre dans lequel elles sont énumérées :
a) fourniture d'un film de substrat (1), par exemple, un film PET ;
b) dépôt d'une couche d'une résine de revêtement (2) sur ledit film de substrat (1) ;
c) réticulation partielle de ladite couche de résine de revêtement (2), de sorte à obtenir un film intermédiaire (10') comprenant ledit film de substrat (1) couvert d'une couche de résine partiellement réticulée (2'), dans lequel le pourcentage de réticulation de ladite résine partiellement réticulée (2') est compris entre 30 % et 70 %, même plus préférablement entre 35 % et 40 %, dans lequel ledit pourcentage de réticulation de la résine est mesuré en procédant à une analyse calorimétrique par balayage différentiel, DSC (Differential Scanning Calorimetry), isotherme ;
e) laminage dudit film intermédiaire (10') sur ledit encapsulant (15) ;
dans lequel, au cours de ladite étape de laminage e), l'exécution complète de la réticulation de ladite couche de résine partiellement réticulée (2') intervient.

3. Le procédé selon la revendication 2, dans lequel ladite étape c) comprend une interruption de ladite réticulation partielle après un intervalle de temps prédéfini inférieur à la durée d'exécution complète de la réaction de réticulation.

4. Le procédé selon l'une quelconque des revendications précédentes, dans lequel ladite résine de revêtement (2) comprend un agent de réticulation bloqué présentant une température de déblocage et capable d'induire une réticulation partielle de ladite couche de résine de revêtement (2) sur exposition à une température supérieure ou égale à ladite température de déblocage, dans lequel ladite température de déblocage est préférablement comprise entre 100 °C et 120 °C, plus préférablement égale à 110 °C.

5. Le procédé selon la revendication 4, où ledit agent de réticulation bloqué inclut l'agent de blocage malonate de diéthyle, DEM (Di-Ethyl-Malonate) ou un isocyanate aliphatique.

6. Le procédé selon l'une quelconque des revendications précédentes, dans lequel ladite résine de revêtement (2) comprend un agent de réticulation et la totalité dudit agent de réticulation est bloquée par un agent de blocage.

7. Le procédé selon l'une quelconque des revendications précédentes, dans lequel ladite réticulation partielle de ladite étape c) est arrêtée après un intervalle temporel entre 10 secondes et 25 secondes, préférablement entre 15 secondes et 20 secondes.

8. Le procédé selon l'une quelconque des revendications précédentes, dans lequel ladite couche de résine de revêtement (2) comprend un solvant pour permettre une exploitabilité du mélange de ladite résine de revêtement (2), par exemple, un méthyléthylcétone et/ou un acétate d'éthyle, et ledit procédé comprend en outre l'étape suivante :
f) une évaporation dudit solvant, par exemple par exposition de ladite résine à une température entre 100 °C et 150 °C,
où ladite étape c) intervient au cours de ladite étape f).

9. Le procédé selon l'une quelconque des revendications précédentes, où ladite réticulation partielle intervient au moyen d'une activation par UV.

10. Le procédé selon l'une quelconque des revendications précédentes, où ledit procédé est exécuté au moyen d'un processus de bobine à bobine.

11. Le procédé selon la revendication 2 ou selon l'une quelconque des revendications 3 à 10 en cas de dépendance à la revendication 2, dans lequel ladite étape e) de lamination intervient au moyen d'une exposition dudit film intermédiaire (10') à une température inscrite dans la plage de 140 °C à 170 °C, préférablement de 140 °C à 160 °C.

12. Le procédé selon l'une quelconque des revendications précédentes, dans lequel ladite étape b) est exécutée parallèlement à une ligne de revêtement et ladite étape c) de réticulation partielle est exécutée parallèlement à ladite ligne de revêtement.

13. Module photovoltaïque (50) comprenant un encapsulant (15) et une feuille de fond (20), dans lequel ledit module photovoltaïque (50) est produit au moyen du procédé selon la revendication 2 ou selon l'une quelconque des revendications 3 à 12 en cas de dépendance à la revendication 2.

14. Film intermédiaire (10') pour une feuille de fond (20) pour des modules photovoltaïques comprenant les couches suivantes :
- un film de substrat (1), par exemple, un film PET ;
- une couche de résine de revêtement partiellement réticulée (2') ;
**caractérisé en ce que** :
le pourcentage de résine réticulée dans ladite couche de résine de revêtement partiellement réticulée (2') est compris entre 30 % et 70 %, même plus préférablement entre 35 % et 40 %, dans lequel ledit pourcentage de réticulation de la résine est mesuré en procédant à une analyse calorimétrique par balayage différentiel, DSC (Differential Scanning Calorimetry), isotherme.

15. Le film intermédiaire (10') selon la revendication 14, dans lequel ladite résine de revêtement (2) comprend un agent de réticulation et la totalité dudit agent de réticulation est bloquée au moyen d'un agent de blocage, dans lequel ledit agent de réticulation inclut par exemple un agent de réticulation par UV.

16. Le film intermédiaire (10') selon l'une quelconque des revendications 14 et 15, dans lequel ladite résine de revêtement (2') inclut une résine acrylique avec une fonctionnalité acrylate.

17. Le film intermédiaire (10') selon l'une quelconque des revendications 14 à 16, dans lequel ladite résine de revêtement (2') inclut des pigments capables d'absorber une lumière visible et transparents à la lumière infrarouge (IR), par exemple, des pigments à base de pérylène.

18. Le film intermédiaire (10') selon l'une quelconque des revendications 14 à 17, dans lequel ledit film intermédiaire (10') est enroulé sur une bobine.
